# EUROPEAN PATENT SPECIFICATION

(11) **EP 3 436 233 B1**
(45) Date of publication and mention of the grant of the patent: **19.02.2020**
(21) Application number: 17714467.2
(22) Date of filing: 30.03.2017
(51) Int. Cl.: B29C 59/02, B29C 70/64, B32B 3/30, H01L 51/00

(54) **POLYMERIC COMPOSITES WITH FUNCTIONAL SURFACES**
POLYMERVERBUNDSTOFFE MIT FUNKTIONELLEN OBERFLÄCHEN
COMPOSITES POLYMÈRES AVEC DES SURFACES FONCTIONNELLES

(30) Priority: 31.03.2016 EP 16382141
(43) Date of publication of application: 06.02.2019
(73) Proprietor: Fundación Imdea Nanociencia, 28049 Madrid (ES)
(72) Inventor: HERNÁNDEZ RUEDA, Jaime, E-28049 Madrid (ES); RODRÍGUEZ FERNÁNDEZ, Isabel, E-28049 Madrid (ES); NAVARRO BAENA, Iván, E-28049 Madrid (ES); VIELA BOVIO, Felipe, E-28049 Madrid (ES)
(74) Representative: ABG Intellectual Property Law, S.L.
(86) International application number: PCT/EP2017/057591
(87) International publication number: WO 2017/167909

(56) References cited:
- US-A1- 2005 103 457
- US-A1- 2013 115 420
- US-A1- 2013 251 948
- US-A1- 2014 072 720

## Description

### FIELD OF THE ART

The present invention relates to a composite comprising a textured surface with a plurality of protrusions and a bulk portion, which presents a variety of surface functionalities such as super-repellency, anti-reflective behavior, or anti-bacterial properties among others.

### STATE OF THE ART

Nowadays, the wide use of polymeric materials is attributed to the combination of factors such as low cost, low weight and ease of processing. Additional or improved properties in terms of mechanical, thermal, optical or electrical behavior can be imparted onto polymeric materials by incorporation of filler particles to form polymer-based composites.

Further, micro and/or nano engineered topographies of specific geometrical features or textures can also provide a range of properties or functions in addition to the ones inherent in a material. For example, by texturing the surface of materials or objects, functionalities such as super-repellency, adhesiveness, reflective or anti reflective behaviour or antimicrobial effects among others can be achieved.

Hence, multi-functional polymeric materials with different properties may be prepared by combining surface engineering technologies such as imprinting by hot embossing with polymer-based composite technology. Thus, for example super-repellent surfaces with extreme repellence to liquids are generally prepared by combining micro and nanostructures hierarchically disposed to trap large amount of air pockets within, and to allow a very low liquid-solid contact area. US 20130115420 A1 discloses superhydrophobic nanocomposites comprising a matrix of thermoplastic polymer or curable polymer, and a nanofiller of carbon material distributed all over the polymeric matrix. The nanocomposite further includes a surface portion comprising a plurality of protrusions. US 20140242345 A1, from the same applicant, discloses a method for preparing a nano-composite layer comprising a superhydrophobic surface, wherein the bulk and the surface of the composite comprise the same material.

Micro and/or nano engineered topographies may also confer antireflective properties. Antireflective surfaces have been usually prepared by quarter wavelength thickness coatings whose refractive index is the square root of the substrate's refractive index. These coatings are effective on reducing reflection, however they lack of broad band reflectivity. Multilayer stacks with alternating thin layers of a high and low refractive index are also used to create interference filters. However, the process to produce these layers is costly. Recently, after the development of nanofabrication technologies, an additional method based on the so-called nanostructured graded-index layer has been developed. The nanostructures employed having a conical geometry, produce a refractive index gradient normal to and increasing towards the substrate surface. The nanostructured coating shows efficient broadband anti-reflective properties and very low angular dependence of color reflection.

US 2014/0072720 A1 discloses compositions and methods for patterning nanocomposite films or coatings containing particles and UV curable, thermally curable and/or chemically cross-linked materials to generate functional patterned nanoparticle structures. The particles are incorporated into the polymers by in-situ generation and/or blending crystalline particles with polymers. The compositions so formed are patterned by imprint lithography.

Micro and/or nano engineered topographies may also confer antimicrobial properties to surfaces. Topographic surface features may deter or inhibit the adhesion of bacteria or the formation of harmful biofilms or may result bactericidal to bacteria by physical membrane rupture. WO 2015031956 A1 discloses a synthetic biocidal surface comprising an array of nanospikes that are lethal to bacteria cells due to piercing onto the cells.

US 2013/251948 A1 relates to a composite comprising a textured surface with a plurality of protrusions.

The documents in the art suggest the use of polymer composites with engineered topographies to achieve different functionalities. However, there is a need in the art for tailored and multifunctional polymer composites having improved functional properties. Moreover, it is also needed a practical methodology to manufacture multifunctional engineered topographies with enhanced properties through low cost and high volume sustainable methods.

### BRIEF DESCRIPTION OF THE INVENTION

The object of the present invention is to provide a composite comprising a polymeric matrix and a functional surface with enhanced mechanical properties, wherein the desired properties of the polymeric matrix, such as transparency, toughness or flexibility, are maintained.

Therefore, in a first aspect, the invention is directed to a composite comprising a) a textured surface with a plurality of protrusions, and b) a bulk portion; wherein both the textured surface and the bulk portion comprise a polymeric matrix and particles having a mean size of between 1 nm and 100 µm, wherein the polymer in the polymeric matrix is a thermoplastic polymer; and wherein said composite is characterized in that the major amount of said particles is concentrated in the textured surface.

In contrast with the composites known in the art, the composite of the invention wherein the major amount of the particles is concentrated in the textured surface, presents improved mechanical properties on the outer surface. Further, the textured surface of the composite with a plurality of protrusions together with the major amount of the particles concentrated in said textured surface, confers additional properties to the composite, in particular to its surface, such as photocatalytic properties or improved bactericidal properties, while other desired properties of the polymeric matrix, such as transparency, toughness or flexibility, are preserved.

In a second aspect, the invention is directed to a process for preparing the composite of the invention, comprising:
a) providing a thermoplastic polymer,
b) providing a stable dispersion of particles,
c) applying the dispersion of particles of step b) on the surface of the polymer of step a) to obtain a particle coating on the polymer,
d) imprinting the coated polymer obtained in step c) by heating until the polymer becomes fluid, and by pressing the coated polymer surface with a mold having micrometric and/or nanometric patterns with cavities, so that the polymer fills the mold cavities; and
e) cooling and demolding the composite surface from step d) to obtain a composite having a textured surface.

The process provided by the present invention is a simple and efficient fabrication process for preparing the composites of the invention. Moreover, the above defined process of the invention supposes a practical and high volume sustainable methodology to obtain the composite of the invention at low cost.

The invention also relates to the composite obtained by the process above defined.

In further aspects, the invention relates to the use of the composite of the invention as structural, super-hydrophobic, anti-dust, antireflective, antimicrobial, or photo-catalytic coating.

In a final aspect, the invention relates to a product having at least a surface coated with the composite of the invention.

### FIGURES

The accompanying drawings, which are incorporated in and constitute a part of this specification, illustrate exemplary embodiments of the invention and, together with the written description, serve to explain the principles of the invention. In the drawings:

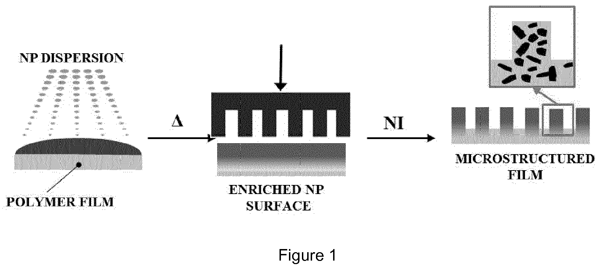

Figure 1: Schematic representation of the process to obtain the composite of the invention.

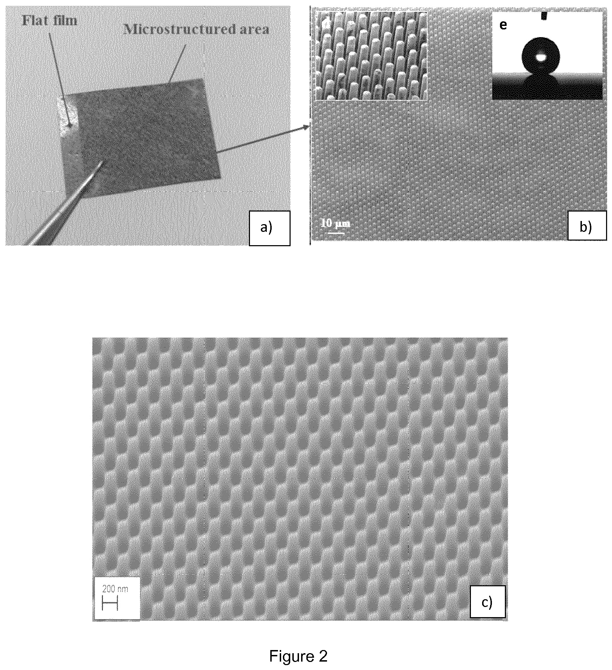

Figure 2: Figures 2a) and b) show a PS/RGO composite film of the invention having a textured surface of 2 µm x 12 µm pillars. Figure 2 b) shows the electronic microscopy image of the textured surface of a PS/RGO composite of the invention. Figure 2d) shows a detail of the pillars of the textured surface. The inset (figure 2e) shows the water drop profile under static conditions (WCA=160°). Figure 2c) shows an electronic microscopy image of a nanoimprinted antireflective PMMA/TiO₂ (PMMA - TiO₂ AR) composite of the invention having conical protrusions of nanometric dimensions.

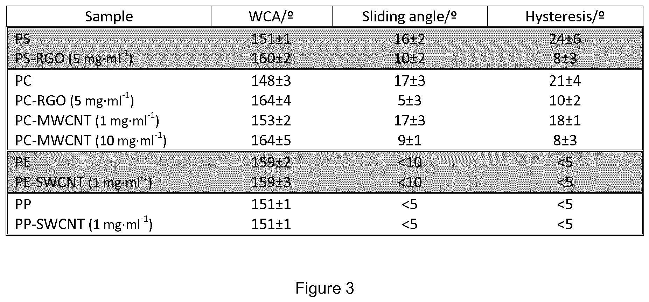

Figure 3: Table showing the water contact angle (WCA), sliding angle and hysteresis of some of the composites of the invention.

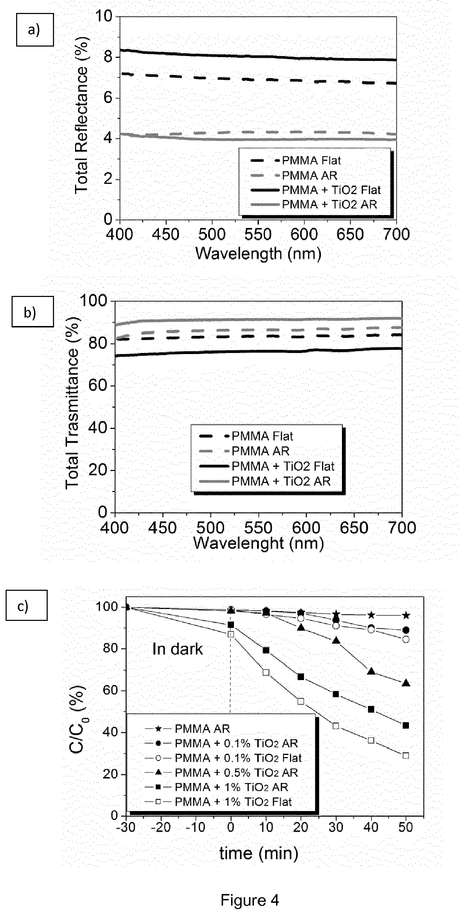

Figure 4: Total reflectance (a) and total transmittance (b) of PMMA flat polymer surface (PMMA flat), imprinted PMMA surface (PMMA AR), TiO₂/PMMA flat composite surface (PMMA + TiO₂ flat), and TiO₂/PMMA composite surface belonging to the invention (PMMA + TiO₂ AR). Figure 4c shows the photo catalytic degradation rate of Rhodamine-B (RhB) for TiO₂/PMMA flat and imprinted antireflective (AR) surfaces containing 0.1, 0.5 and 1% wt of TiO₂ particles.

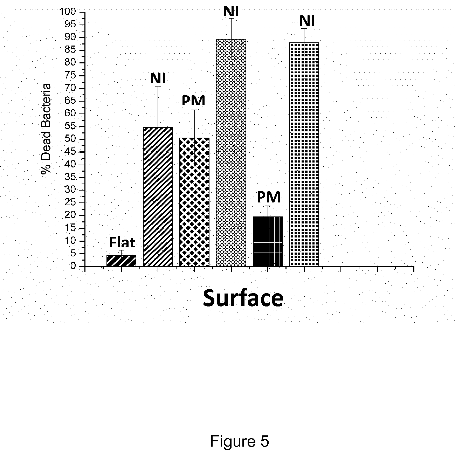

Figure 5: Average rate of bactericidal properties of PMMA flat and imprinted PMMA surface (NI PMMA), PMMA/TiO₂ flat composite surface (PMMA - TiO₂), PMMA/TiO₂ composite surface of the invention (NI PMMA - TiO₂), PMMA/ZnO flat composite surface and PMMA/ZnO composite surface of the invention (NI PMMA-ZnO). Error bars correspond to standard deviation.

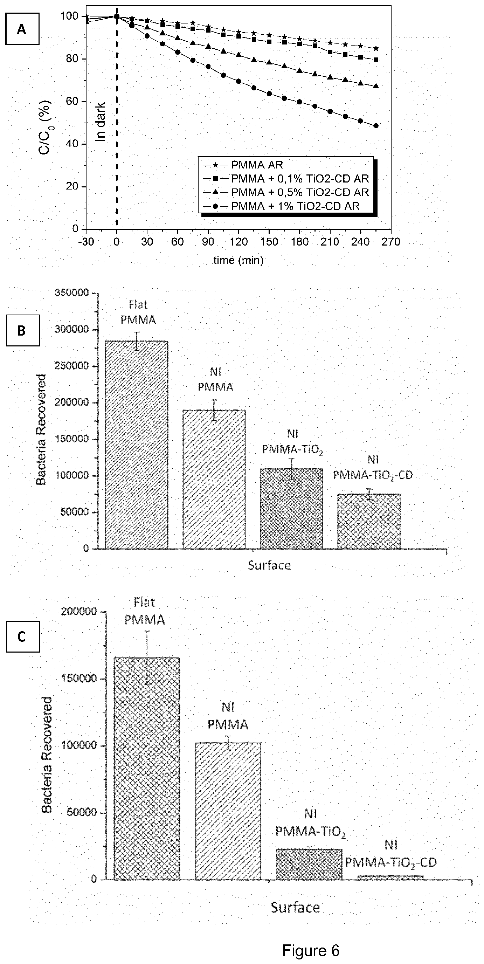

Figure 6A: Photo catalytic degradation rate of Rhodamine-B (RhB) by imprinted AR PMMA composites surfaces containing 0.1, 0.5 and 1% wt. of TiO₂ doped with carbon dots (TiO₂-CD)/PMMA upon visible light irradiation. Figures 6B and 6C show in absolute numbers the S. aureus and E.coli bacteria cells remaining alive after the illumination period for flat and imprinted PMMA surface (NI PMMA), PMMA/TiO₂ imprinted composite surface (NI PMMA - TiO₂), and (TiO₂-CD) /PMMA imprinted surface.

### DETAILED DESCRIPTION OF THE INVENTION

The present invention relates to a composite comprising a) a textured surface with a plurality of protrusions, and b) a bulk portion; wherein both the textured surface and the bulk portion comprise a polymeric matrix and particles having a mean size of between 1 nm and 100 µm, wherein the polymer in the polymeric matrix is a thermoplastic polymer; and wherein said composite is characterized in that the major amount of said particles is concentrated in the textured surface.

By the term "composite" it is understood a polymeric matrix containing a filler of particles. In the present invention said composite presents a textured surface, wherein the major amount of the particles is mainly located or concentrated in the textured surface of the composite. The terms "surface-rich composite" or "nano/microstructured surface-rich composite" are also used to refer to the composite of the invention in the context of the present invention.

In a particular embodiment, between 30 % and 99% wt. of the total amount of the particles in the composite is concentrated in the textured surface. Preferably, between 60 and 90% wt. of the total amount of the particles in the composite of the invention is concentrated in the textured surface. More preferably, between 70 and 85% wt. of the particles in the composite is concentrated in the textured surface of the composite, even more preferably between 75 and 80% wt.

The term "textured surface" in the context of the present invention refers to the surface of the composite of the invention having a plurality of micro- or nanometric protrusions, or having a plurality of hierarchical micro- and nanometric protrusions. The protrusions in the composite of the invention may have any common regular and/or irregular shapes, such as a spherical shape, elliptical shape, cubical shape, tetrahedral shape, pyramidal shape, octahedral shape, cylindrical shape, cylindrical shape, polygonal pillar-like shape, conical shape, columnar shape, tubular shape, helical shape, funnel shape, or dendritic shape. Each of the protrusions may have the same or different shape, height, and width. In a particular embodiment, the protrusions have a columnar shape or a conical shape.

In one embodiment, the protrusions in the textured surface of the composite of the invention present a height of between 5 nm and 1000 µm, preferably between 5 nm and 100 µm, more preferably of between 10 nm and 20 µm, more preferably between 50 nm and 10 µm, more preferably of between 100 nm and 500 nm, even more preferably between 200 nm and 400 nm, even more preferably between 250 and 300 nm. In another preferred embodiment, the protrusions in the textured surface present a height of between 1 µm and 12 µm.

In one embodiment, the protrusions in the textured surface of the composite of the invention present a width between 5 nm and 1000 µm, preferably between 5 nm and 100 µm, more preferably between 10 nm and 20 µm, more preferably of between 50 nm and 10 µm, more preferably of between 100 nm and 500 nm, even more preferably between 200 nm and 400 nm, even more preferably between 250 and 300 nm. In another preferred embodiment, the protrusions in the textured surface present a width of between 1 µm and 2 µm.

In one embodiment, the protrusions in the textured surface of the composite of the invention present an interval between the protrusions or pitch of between 5 nm and 1000 µm, preferably between 5 nm and 100 µm, more preferably of between 10 nm and 20 µm, more preferably of between 50 nm and 10 µm, more preferably of between 100 nm and 500 nm, even more preferably between 200 nm and 400 nm, even more preferably between 250 and 300 nm. In another preferred embodiment, the protrusions in the textured surface present an interval of between 1 µm and 4 µm. The intervals between the protrusions may also be the same or different.

In a particular embodiment, the composite of the invention comprises a textured surface with a plurality of protrusions, wherein the protrusions in the textured surface present a height of between 5 nm and 1000 µm, a width of between 5 nm and 1000 µm, and an interval between the protrusions from 5 nm to 1000 µm. In another particular embodiment, the protrusions in the textured surface of the composite of the invention present a height of 12 µm, a width of 2 µm and an interval between protrusions of 4 µm.

The polymer in the polymeric matrix of the composite of the invention is a thermoplastic polymer. In a particular embodiment, the thermoplastic polymer is selected from poly(methyl methacrylate) (PMMA), polycarbonate (PC), polystyrene (PS),cellulose acetate (CA) and mixtures thereof. In another particular embodiment the thermoplastic polymer is a polyolefin selected from polypropylene (PP), polyethylene (PE), and mixtures thereof. In another particular embodiment the thermoplastic polymer is selected from polylactic acid (PLA), polycaprolactone (PCL), polyhydroxyalkanoate (PHA), polyhydroxybutyrate (PHB), polyethylene adipate (PEA), polybutylene succinate (PBS), poly(3-hydroxybutyrate-co-3-hydroxyvalerate) (PHBV), polytrimethylene terephthalate (PTT), polyethylene naphthalate (PEN) and mixtures thereof. In a preferred embodiment the thermoplastic polymer is selected from polyglycolide (PGA), poly(propylenefumarate) (PPF), polycyanoacrylate (PCA), polycaprolactone (PCL), poly(glycerol sebacate) (PGS), poly(glycerol sebacate acrylate) (PGSA), polyvinylidenefuoride (PVDF), polyvinylidene chloride (PVDC), polyethylene terephthalate (PET), polybutylene therephtalate (PBT), polyphenylene oxide (PPO), polyvinyl chloride (PVC), cellulose acetate, cyclic olefin copolymer (COC), ethylene vinyl acetate (EVA), ethylene vinyl alcohol, (EVOH), polyethersulfone (PES), chlorinated poly ethylene (CPE), poly 3-hydroxybutyrate (P3HB), polybutylene adipate (PBA), polyethylene adipate (PEA), polybutylene succinate (PBS), polyphenylene sulfide (PPS), polysulfone (PSU), polytrimethylene terephthalate (PTT), polyurethane (PU), polyvinyl acetate (PVAc), styrene acrylonitrile (SAN), and mixtures thereof. In another particular embodiment the thermoplastic polymer is selected from polyetherketones (PEEK), polyvinylalcohol (PVA), polyhydroxyethylmethacrylate polyvinylalcohol (PHMM-PVA), polyhydroxyethylmethacrylate (PHEMA), poly(N-isopropylacrylamide) (PNIPAAm) and mixtures thereof. In a preferred embodiment the polymer in the polymeric matrix is polystyrene (PS), polycarbonate (PC), polyethylene (PE), polypropylene (PP), poly(methyl methacrylate) (PMMA) and mixtures thereof.

In a preferred embodiment, the thermoplastic polymer is selected from poly(methyl methacrylate) (PMMA), polycarbonate (PC), polystyrene (PS), polypropylene (PP), polyethylene (PE), polyglycolide (PGA), poly(propylenefumarate) (PPF), polycyanoacrylate (PCA), polycaprolactone (PCL), poly(glycerol sebacate) (PGS), poly(glycerol sebacate acrylate) (PGSA), polyvinylidenefuoride (PVDF), polyvinylidene chloride (PVDC), polyethylene terephthalate (PET), polybutylene therephtalate (PBT), polyphenylene oxide (PPO), polyvinyl chloride (PVC), cellulose acetate (CA), cyclic olefin copolymer (COC), ethylene vinyl acetate (EVA), ethylene vinyl alcohol, (EVOH), polytetrafluoroethylene (PTFE), fluorinated ethylene propylene (FEP), perfluoroalkoxy (PEA), ethylene tetrafluoroethylene (ETFE), polyethersulfone (PES), chlorinated poly ethylene (CPE), polylactic acid (PLA), poly 3-hydroxybutyrate (P3HB), polybutylene adipate (PBA), polyethylene adipate (PEA), polybutylene succinate (PBS), polyphenylene sulfide (PPS), polysulfone (PSU), polytrimethylene terephthalate (PTT), polyurethane (PU), polyvinyl acetate (PVA), polyvinylidene chloride (PVDC), styrene acrylonitrile (SAN), polyetherketones (PEEK), polyvinylalcohol (PVA), polyhydroxyethylmethacrylate (PHEMA), poly(N-isopropylacrylamide) (PNIPAAm) and mixtures thereof.

The particles of the composite of the invention present a mean size of between 1 nm and 100 µm. In the context of the present invention by the term "mean size" it is understood the average size of the largest dimension of each particle of the composite of the invention. Preferably, the particles of the composite of the invention present a mean size of between 2 nm and 80 µm, more preferably, between 10 nm and 50 µm, more preferably between 20 nm and 30 µm, even more preferably from 50 nm and 15 µm. In a preferred embodiment, the particles of the composite of the invention present a mean size of between 100 nm and 10 µm, more preferably of between 200 nm and 5 µm, more preferably of between 300 nm and 3 µm, even more preferably of between 500 nm and 2 µm. In a more preferred embodiment, the particles of the composite of the invention present a mean size of between 700 nm and 1 µm, preferably between 800 nm and 900 nm.

In a particular embodiment, the particles in the composite of the invention are selected from carbon based particles, metal particles, metal oxide particles, sulphide particles, carbide particles, nitride particles, and mixtures thereof.

In another particular embodiment the particles in the composite of the invention are carbon based particles selected from carbon nanotubes, carbon nanowires, reduced graphene oxide flakes (RGO), carbon nanoribbons, carbon nanorods, carbon nanodots, fullerenes, graphene flakes, carbon black, graphite, carbon nanofibers and mixtures thereof. Preferably, the particles in the composite of the invention are carbon nanotubes, carbon nanofibers, reduced graphene oxide flakes (RGO) or mixtures thereof.

In another particular embodiment the particles in the composite of the invention are elongated structures selected from carbon nanofibers, carbon nanotubes, carbon nanoribbons, carbon nanorods, carbon nanowires and mixtures thereof. In another particular embodiment, the particles of the composite of the invention are elongated structures having a mean size of between 0.5 µm and 100 µm, wherein said mean size corresponds to the length of the elongated structure. Preferably, the particles of the composite of the invention are elongated structures having a mean size of between 0.5 µm and 80 µm, preferably of between 2 µm and 50 µm, more preferably of between 10 µm and 30 µm, even more preferably of between 15 µm and 25 µm.

In a preferred embodiment, the particles in the composite of the invention are carbon nanotubes (CNTs). Preferably, the particles in the composite of the invention are single walled carbon nanotubes (SWCNT), multiwalled carbon nanotubes (MWCNT) or mixtures thereof.

In a preferred embodiment, the particles in the composite of the invention are single walled carbon nanotubes (SWCNT) having an average diameter of between 0.5 to 3 nm. In a more preferred embodiment, the particles in the composite of the invention are single walled carbon nanotubes (SWCNT) having an average diameter of between 0.5 to 3 nm and a length of between 0.5 µm and 100 µm, preferably a length of between 2 to 30 µm.

In another preferred embodiment, the particles in the composite of the invention are multiwalled carbon nanotubes (MWCNT) having an average diameter of between 4 to 40 nm, preferably of between 10 to 30 nm. In a more preferred embodiment, the particles in the composite of the invention are multiwalled carbon nanotubes (MWCNT) having an average diameter of between 4 to 40 nm of diameter, preferably of between 10 to 30 nm of diameter and a length of between 0.5 µm and 100 µm, preferably a length of between 2 to 30 µm.

In another particular embodiment, the particles in the composite are metal particles such as silver (Ag), aluminum (Al), gold (Au), bismuth (Bi), cobalt (Co), chrome (Cr), copper (Cu), iron (Fe), germanium (Ge), indium (In), iridium (Ir), molybdenum (Mo), neodymium (Nd), nickel (Ni), palladium (Pd), platinum (Pt), rhodium (Rh), ruthenium (Ru), silicon (Si), tin (Sn), tantalum (Ta), titanium (Ti), tungsten (W), zinc (Zn), and their alloys.

In another particular embodiment, the particles in the composite of the invention are selected from ruthenium dioxide (RuO₂), titanium dioxide (TiO₂), iridium dioxide (IrO₂), zirconium dioxide (ZrO₂), hafnium dioxide (HfO₂), zinc oxide (ZnO), silicon (Si), barium titanate (BaTiO₃), strontium titanate (SrTiO₃), aluminum oxide (Al₂O₃), yttrium oxide (Y₂O₃), cerium oxide (CeO₂), indium oxide (In₂O₃) doped with tin oxide (SnO₂) (indium tin oxide), antimony oxide (Sb₂O₃) doped with tin oxide (SnO₂)(antimony tin oxide), Al₂O₃ doped with ZnO (antimony zinc oxide), iron oxide (Fe₂O₃, Fe₃O₄), iron platinum (FePt), metal chalcogenides, such as: lead sulfide (PbS), gallium phosphide (GaP), indium phosphide (InP), lead selenide (PbSe), lead telluride (PbTe), and mixtures thereof. In a preferred embodiment the particles in the composite of the invention are selected from metal and metal oxide particles doped with carbon dots, more preferably, the particles in the composite of the invention are titanium dioxide particles doped with carbon dots.

In another particular embodiment, the particles in the composite of the invention are metal sulphide particles selected from molybdenum disulphide (MoS₂), tungsten disulfide (WS₂) particles and mixtures thereof.

In another particular embodiment, the particles in the composite of the invention are nitride particles. Preferably, the particles in the composite of the invention are boron nitride (BN) particles.

In another particular embodiment, the particles in the composite of the invention are core-shell particles or Janus type of particles.

In another particular embodiment, the particles in the composite of the invention are metal oxide particles selected from silica, alumina, titanium oxide (or titania particles), zinc oxide, nickel oxide, silver oxide, copper oxide and mixtures thereof. Preferably, the particles in the composite of the invention are titanium oxide, zinc oxide or mixtures thereof. More preferably, the particles in the composite of the invention are metal oxide particles with sizes ranging from 5 to 200 nm, preferably with sizes ranging from 10 to 100 nm, more preferably from 30 to 50 nm.

In another particular embodiment, the particles in the composite of the invention are selected from reduced graphene oxide flakes/TiO₂, carbon nanotubes/TiO₂, carbon nanodots/TiO₂, Au/TiO₂ and mixtures thereof. The inventors have found that these particular combinations broad the spectrum of photocatalytic activity and improve the efficiency of the composite of the invention.

The particles in the composite of the invention may have the surface unmodified (pure) or have the surface modified by ligand-coated or ligand bound molecules.

The composite of the invention can be used as a free-standing material, or adhered onto a surface, or coated on a surface of a product. Thus, in a particular embodiment, the invention relates to a product having at least a surface coated with the composite of the invention. The product coated with the composite of the invention may have one or more surfaces coated with the composite of the invention. Preferably, the composite of the invention coating at least a surface of the product may present a thickness of between 10 µm and 1 mm, preferably of between 30 µm and 750 µm, more preferably of between 100 µm and 500 µm. Suitable products that may be coated with the composite of the invention include products made of plastic, glass, metals, stainless steel and ceramics.

### Process for preparing the composite

In one aspect, the invention relates to a process for preparing the composite of the invention, comprising:
a) providing a thermoplastic polymer,
b) providing a stable dispersion of particles,
c) applying the dispersion of particles of step b) on the surface of the polymer of step a) to obtain a particle coating on the polymer,
d) imprinting the coated polymer obtained in step c) by heating until the polymer becomes fluid, and by pressing the coated polymer surface with a mold having micrometric and/or nanometric patterns with cavities, so that the polymer fills the mold cavities; and
e) cooling and demolding the composite from step d) to obtain a composite having a textured surface.

According to step a) of the process of the invention, a thermoplastic polymer is provided. Suitable thermoplastic polymer in the process of the invention include poly(methyl methacrylate) (PMMA), polycarbonate (PC), polystyrene (PS), polypropylene (PP), polyethylene (PE), polyglycolide (PGA), poly(propylenefumarate) (PPF), polycyanoacrylate (PCA), polycaprolactone (PCL), poly(glycerol sebacate) (PGS), poly(glycerol sebacate acrylate) (PGSA), polyvinylidenefuoride (PVDF), polyvinylidene chloride (PVDC), polyethylene terephthalate (PET), polybutylene therephtalate (PBT), polyphenylene oxide (PPO), polyvinyl chloride (PVC), cellulose acetate (CA), cyclic olefin copolymer (COC), ethylene vinyl acetate (EVA), ethylene vinyl alcohol (EVOH), polytetrafluoroethylene (PTFE), fluorinated ethylene propylene (FEP), perfluoroalkoxy (PEA), ethylene tetrafluoroethylene (ETFE), polyethersulfone (PES), chlorinated poly ethylene (CPE), polylactic acid (PLA), poly 3-hydroxybutyrate (P3HB), polybutylene adipate (PBA), polyethylene adipate (PEA), polybutylene succinate (PBS), polyphenylene sulfide (PPS), polysulfone (PSU), polytrimethylene terephthalate (PTT), polyurethane (PU), polyvinyl acetate (PVA), polyvinylidene chloride (PVDC), styrene acrylonitrile (SAN), polyetherketones (PEEK), polyvinylalcohol (PVA), polyhydroxyethylmethacrylate (PHEMA), poly(N-isopropylacrylamide) (PNIPAAm) and mixtures thereof.

According to step b) of the process of the invention, a stable dispersion of particles is provided. Suitable stable dispersions of particles may be prepared using appropriated solvents to the type of particles used. Any solvent appropriate for the preparation of a stable dispersion of particles can be employed, independently of the polymer used. In particular embodiments, solvents providing stable particle dispersion that at the same time, attack the polymer surface and consequently enhance the incorporation of the dispersed particles into the polymer may be preferred. Preferred solvents for the preparation of a stable dispersion of particles include methanol, 2-propanol, chloroform, toluene, anisole, cyclohexane, dimethyl formamide, methanol, dichloromethane, trichloroethane, water, acetone, ethyl acetate, N-methyl-2-pyrrolidone and the like. In particular, toluene, dimethyl formamide and methanol are preferred when the particles are carbon based materials such as carbon nanotubes, carbon nanowires, reduced graphene oxide flakes (RGO), carbon nanoribbons, carbon nanorods, carbon nanodots, fullerenes, graphene flakes, carbon black, graphite, carbon nanofibers or mixtures thereof.

In a preferred embodiment, when the thermoplastic polymer provided in step a) of the process of the invention is PC or PMMA, and the particles in the dispersion of step b) are TiO₂ and/or ZnO, the organic solvent in the stable dispersion of particles provided in step b) is methanol.

In another preferred embodiment, when the thermoplastic polymer provided in step a) of the process of the invention is PP or PE, and the particles in the dispersion of step b) are SWCNT and/or MWCNT, the organic solvent in the dispersion of particles provided in step b) is xylene.

In another preferred embodiment, when thermoplastic polymer provided in step a) of the process of the invention is PS, and the particle in the dispersion of step b) is RGO, the organic solvent in the dispersion of particles provided in step b) is methanol.

In a particular embodiment, the dispersion of particles in step b) of the process of the invention contains between 0.001 and 50% wt. of particles, preferably between 0.01 and 30% wt. even more preferably between 0.1 and 15% wt of particles. In a preferred embodiment, the dispersion of particles contains between 0.5 and 10% wt. of particles, preferably between 1 and 5 % wt. of particles, more preferably between 2 and 3 %wt. of particles. The dispersion of particles in step b) may contain between 0.01 and 20 mg/ml of particles, preferably from 0.05 to 15 mg/ml, more preferably from 0.1 to 10 mg/ml. In a more preferred embodiment, the dispersion contains between 0.5 and 5 mg/ml, even more preferably between 1 and 3 mg/ml.

The stable dispersion of particles provided in step b) may be prepared by dispersing the particles in a suitable solvent via ultrasonication for adequate time to separate particle aggregates. The stable dispersion of particles provided in step b) may be also prepared by alternating ultrasonication in an ultrasonic bath or ultrasonic horn and stirring cycles using Ultraturrax dispersion tool at 10000 rpm. Other alternatives known in the art to prepare stable dispersions that are suitable for the process of the invention include the addition of surface tension control additives (surfactants) to the dispersion of particles, or modification of the particle surface by bound or unbound ligand molecules. Suitable surfactants include among others: hexadecyltrimethylammonium chloride (HDTMAB), sodium, cetyl trimethyl ammonium bromide (CTAB), dodecyl sulfate (SDS), TritonX-100, Brij, polyethylene glycol (PEG), polyvinylpyrrolidone (PVP) or polyacrylamide (PAM). Moreover, methods to prepare stable dispersions are well-known in the art as reported by W. Yu and H. Xie [Journal of Nanomaterials Volume 2012, Article ID 435873, 17 pages doi:10.1155/2012/435873]. W. Yu and H. Xie reviews the methods known in the art to prepare stable dispersion of particles, as well as the methods to evaluate the stability of dispersions of particles.

In particular the dispersion of particles is considered to be stable when there is no apparent sediment of nanoparticles appreciable with time because the concentration or particle size of supernatant particles keeps constant with time. Sedimentation observation is a usual method for assessing the stability of the dispersions.

Moreover, the stability of the dispersion of particles can be also assessed by spectrophotometer analysis because there is a linear relation between the supernatant nanoparticle concentration and the absorbance of suspended particles. The nanomaterials dispersed in fluids have characteristic absorption bands in the wavelength 190-1100 nm. The dispersion of particles is considered to be stable when the absorption signal of a the dispersion remains constant with time indicating that the concentration or particle size of supernatant keeps constant, as disclosed by W. Yu and H. Xie.

Further, the zeta potential of the dispersion can also be related to the stability of dispersions. Thus, dispersions with high zeta potential value (negative or positive) are electrically stabilized, while dispersions with low zeta potentials tend to coagulate or flocculate. In general, a zeta potential of 25 mV (positive or negative) is considered as the arbitrary value that separates low-charged surfaces from highly charged surfaces. The dispersions of particles with zeta potential from 40 to 60 mV are considered to have good stability, while those with more than 60 mV are considered to have an excellent stability. Thus for example, when a dispersion of TiO₂ particles in methanol (0.1-1% wt.) is provided in step b), as disclosed in example 4 of the present application, said dispersion presents a Zeta potential of -40 mV in a pH range of 6 to 10, is therefore considered a stable dispersion of particles.

In particular, the particles should not aggregate and flocculate in the time frame of the fabrication process, i.e.: from several minutes to hours to days.

The dispersion of particles provided in step b) of the process of the invention may also contain a binder or matrix material. In a preferred embodiment, this binder or matrix material is the same thermoplastic polymer provided in step a) of the process of the invention. The binder may be also another compatible polymer resin such as polyacrylate, polyurethane, epoxy resins, phenol resins, polyester resins, thermo curing resins or light sensitive resins.

According to step c), the dispersion of particles of step b) is applied on the surface of the polymer of step a) to obtain a particle coating on the polymer.

In a particular embodiment, the dispersion of particles is applied on the surface of the polymer in step c) by casting, spin coating, screen printing, jet printing, gas-assisted spraying, roll to roll printing or gravure roll coating. Preferably, the dispersion of particles is applied on the surface of the polymer by casting, spin coating, gas-assisted spraying or gravure roll coating.

In a particular embodiment, 100 µl of the dispersion of particles are applied per 1 cm² polymeric surface in step c) of the process of the invention. In other particular embodiment, 1 ml of the dispersion of particles is applied on a 6 cm x 6 cm polymeric surface in step c) of the process of the invention. In another particular embodiment, 100 µl of the dispersion of particles is applied on a circular polymeric surface having 20 mm diameter in step c) of the process of the invention.

If necessary, the excess of solvent of the particle dispersion may be eliminated by vacuum drying (500 - 20 mbar) or by light heating.

In a particular embodiment, the stable dispersion of particles provided in step b) of the process of the invention is applied on the surface of the polymer according to step c) on a large scale process using a reverse gravure roll coating approach. In particular, the process of reverse gravure roll coating allows coating fluids of viscosities up to 1000 mPa.s onto substrates, typical viscosity range is 5-20 mPa.s. Gravure roll coating makes use of an engraved cylinder roll typically an Anilox roll. This roll has engraved on its surface micro cavities or cells with different sizes and shapes such as quadrangular, pyramidal, trihelical or hexagonal, which determine the amount of coating fluid that is applied. Coat thicknesses in the range of less than 1 micron up to 30 microns can be achieved. A Mayer type rod can also be used. In this case the amount of fluid applied is controlled by the diameter of the wire used to make the rod.

Corona treatment with oxygen plasma of the polymer film can be employed to increase the surface energy of the film, and consequently, the adhesion of the particles coated on the surface.

The engraved cylinder rotates inside a reservoir dispersed particles where small amounts of liquid material fill into the cells' cavities. The excess outside the cells is removed by a doctor blade. Subsequently, as the Anilox cylinder rolls off, it makes contact on the opposite side with a polymer film that is rolled across. The dispersion of particles is transferred to the polymer film by capillary action arising upon contact.

The coated polymer obtained from step c) of the process of the invention is imprinted according to step d) by heating until the polymer becomes fluid, and by pressing the coated polymer surface with a mold having micrometric and/or nanometric patterns with cavities, so that the polymer fills the mold cavities. Due to the heat and pressure applied during the imprinting step, the polymer chain mobility is increased so that the softened polymer fills the mold cavities (see scheme in figure 1). Moreover, the polymer flow incorporates the particles deposited on the surface in step c), that remain finally embedded on the polymer at the end of the process, giving rise to the formation of reinforced micro/nanostructured surface features.

The mold may be designed with the required features and fabricated by micro-nano fabrication techniques in silicon, quartz or any other suitable material. Subsequently, this master mold can be copied into nickel (Ni) or polymers such polydimethylsiloxane (PDMS), polyurethane acrylate (PUA), perfluoropolyether (PFPE) acrylates, ethylene-tetrafluoroethylene (ETFE), Teflon or the like to be used as working mold for the nanoimprint process.

Preferably, the pressure applied during the imprinting step d) is from 1 to 200 bar, more preferably between 10 to 70 bar, even more preferably between 20 and 50 bar. In a preferred embodiment, the temperature applied during the imprinting step d) is of between 140 to 180 °C, preferably of between 150 and 160 °C. In a particular embodiment, when the coated polymer from step b) is polystyrene, a temperature of between 140 °C and 160 °C and a pressure of between 20 and 50 bar are applied during step d).

In a particular embodiment, when the coated polymer from step c) of the process of the invention is polycarbonate or propylene, a temperature of 180 °C and a pressure of between 20 and 50 bar are applied during imprinting step d) of the process of the invention.

In another particular embodiment, when the coated polymer from step b) of the process of the invention is polyethylene, a temperature of 140 °C and a pressure of between 20 and 50 bar are applied during imprinting step d) of the process of the invention.

In a particular embodiment, the imprinting step according to step d) of the process is carried out on a large scale process by roll-to roll imprinting. By this technique, the polymer is in-feed by an unwinder roller. As the film is continuously coated, another roller pulls and feeds it to the imprinting rollers. The coated polymer of step c) is pressed against a roller mold by a pressure roller. The pressure applied can be from 0 up to 50 MPa. The roller mold is typically a thin electroplated nickel or plastic master replica wrapped on to a cylinder with micrometer to nanometer resolution fine patterns. In a particular embodiment, the roller mold is a solid cylinder with patterned features on its surface. At the point where printing roll makes contact to the pressure roll, the temperature is raised above the glass transition temperature of the polymeric material. As such, when the pressure roller is pressed against the mold, the imprint pattern is transferred to the coated polymer of step c). At the same time, and due to the increased polymer mobility at the high temperature, the particles impregnate the top layer of the polymer forming the surface-rich composite of the invention.

As the printing mold rolls away, the composite temperature decreases and as result, the composite hardens, and the imprinted patterns can be released from the mold at the molding roller which is rotating in the opposite direction. The imprinted composite is collected by a re-wind roller. The polymer film tension together with the roller speed is crucial for the quality of the imprint process. In this process, web speeds range from 0.5 to 2 m/minute, pressures up to 10 MPa and web fed tension of 10-20 Kg are typical.

Thus, in a particular embodiment step c) is carried out using a reverse gravure roll coating approach, and step d) of the process of the invention is carried out by roll to roll imprinting.

According to step e) of the process of the invention, the composite from step d) is cooled and demolded to obtain the composite of the invention having a textured surface.

In a particular embodiment, the invention relates to the composite obtained by the process of the invention. The composite obtained by the process of the invention comprises a) a textured surface with a plurality of protrusions, and b) a bulk portion; wherein both the textured surface and the bulk portion comprise a polymeric matrix and particles having a mean size of between 1 nm and 100 µm, wherein the polymer in the polymeric matrix is a thermoplastic polymer, and wherein said composite is characterized in that the major amount of said particles is concentrated in the textured surface.

The major amount of the particles concentrated in the textured surface of the composite reinforce said portion of the composite improving the mechanical properties of the textured surface, while the properties of the bulk portion remain practically unaffected. Thus, a particular embodiment refers to the use of the composite as structural coating.

### Composites with a super-repellent surface

The reduced area of contact of the textured composite of the invention decreases the adhesion of fluids such as oil or water, particles of dust, biological entities etc.

In the context of the present invention, a surface is considered superhydrophobic when it shows a water contact angle (WCA) ≥150°, and it is considered self-cleaning when the contact angle hysteresis, that is, the difference between the advancing (maximal) and receding (minimal) angle, is below 10°. In general these surfaces are termed super-repellent. The textured surface of the composites of the invention presents large static and advancing contact angles, and a small contact angle hysteresis to water and organic solvents. Figure 3 shows the wetting properties of composites belonging to the invention. The composites shown in the table having a WCA over 150° are considered superhydrophobic in the context of the present invention. Further, composites PS-RGO (5 mg/ml RGO particles), PC-MWCNT (10 mg/ml MWCNT) or PE-SWCNT (1 mg/ml SWCNT) or PP-SWCNT (1 mg/ml SWCNT), belonging to the invention show contact angle hysteresis below 10°, and therefore present self-cleaning properties.

Thus, in one embodiment the invention relates to the use of the composite of the invention as super-hydrophobic coating for repelling liquids or anti-dust coating.

In another particular embodiment, the invention relates to the use of the composite of the invention wherein the particles are carbon based particles, metal particles, metal oxide particles, sulphide particles, carbides particles, nitrides particles, and mixtures thereof, as super-hydrophobic coating for repelling liquids. In a particular embodiment, the invention relates to the use of the composite wherein the particles are carbon based particles selected from carbon nanotubes, carbon nanowires, reduced graphene oxide flakes (RGO), carbon nanoribbons, carbon nanorods, carbon nanodots, fullerenes, graphene flakes, carbon black, graphite, carbon nanofibers and mixtures thereof, as super-hydrophobic coating for repelling liquids.

Thus, in another particular embodiment the invention relates to the use of the composite wherein the particles are carbon based particles, metal particles, metal oxide particles, sulphide particles, carbides particles, nitrides particles, and mixtures thereof, as water or oil repellent or as anti-dust coating. These surfaces have been termed self-cleaning surfaces as water drops, and particles roll off easily from them. Moreover, the low adhesive properties of water to the surface of the mentioned composites of the invention prevent or delay the ice formation and/or decrease the energy required to defrost the surface. In this sense, the mentioned composites are of particular interest in aeronautical industry, especially for airplane wings and for vehicles operating below the freezing temperature. Furthermore, the water/oil repulsion of the composite of the invention also leads to drag reduction. These properties are particularly advantageous to improve the transportation of liquids in pipes in many production plants, or even in packages of food or consumer products to facilitate the drainage of containers. Other application derived from the water repulsion ability of the composite of the invention is the prevention of corrosion in humid conditions.

### Antimicrobial properties

In the biomedical field, or food packaging sector super repellent surfaces, such as the composite of the invention, reduce the undesired proliferation of bacteria in medical devices and implants or food containers. In particular, the textured surface of the composite of the invention reduce bacteria colonization by reducing the area of adhesion or by mechanical rupture, and the particles within the composite causing a bactericidal effect, produce a synergistic biocidal effect. Figure 5 shows a comparative graph wherein it is represented the average rate of bactericidal properties of PMMA (flat) and PMMA nanoimprinted (NI-PMMA), PMMA-TiO₂ flat composite surface and PMMA-TiO₂ nanoimprinted composite surface (NI PMMA-TiO₂), PMMA-ZnO flat composite surface and PMMA-ZnO nanoimprinted composite surface (NI PMMA-ZnO) surface belonging to the invention.

In a particular embodiment, the invention relates to the use of the composite of the invention as antimicrobial material. In another particular embodiment, the invention relates to the use of the composite of the invention as antimicrobial coating.

Further, in a preferred embodiment the composite of the invention comprises particles with bactericidal properties selected from metal and/or metal oxide particles, metal sulphide particles or nitride particles, and mixtures thereof. Thus, in a particular embodiment the invention relates to the use of the composites of the invention wherein the particles are metal, metal oxide particles, metal sulphide particles, nitride particles and mixtures thereof; or a mixture of metal, metal oxide, metal sulphide or nitride particles with metal or carbon based particles, as antimicrobial coating. In a preferred embodiment, the particles are selected from metal and metal oxide particles doped with carbon dots. In another particular embodiment, the invention relates to the use of the composite of the invention wherein the particles are metal oxide particles selected from titanium oxide (or titania particles), zinc oxide, nickel oxide, silver oxide, copper oxide, silica, alumina and mixtures thereof; metal sulphide particles selected from molybdenum disulphide, tungsten disulfide and mixtures thereof; and/or boron nitride particles, as antimicrobial coating.

In another particular embodiment, the invention relates to the use of the composite of the invention wherein the particles are metal particles selected from Ag, Cu, Ni, Zn, Cr, Fe, In, Ir, Mo, Pd, Pt, and Ti.

Preferably, the particles of the composite of the invention with antimicrobial properties are ZnO, TiO₂, CuO and Ag or Cu with a mean size of between 10 and 200 nm, pure or doped with metal or carbon based particles with a mean size of between 2 and 100 nm, preferably with a mean size of between 3 and 100 nm. More preferably, the particles of the composite of the invention with antimicrobial properties are TiO₂ doped with carbon dots, even more preferably the particles of the composite are TiO₂ doped with carbon dots wherein the carbon dots have a mean size of between 2 and 5 nm.

In a particular embodiment, the composite of the invention with antimicrobial properties comprises a) a textured surface with a plurality of protrusions, and b) a bulk portion; wherein the composite comprises a polymeric matrix of PMMA and TiO₂ particles having a mean size of 20 nm, wherein the major amount of TiO₂ particles is concentrated in the textured surface.

In another preferred embodiment, the composite of the invention with antimicrobial properties comprises a) a textured surface with a plurality of protrusions, and b) a bulk portion; wherein the composite comprises a polymeric matrix of PMMA and ZnO particles having a mean size of 20 nm, wherein the major amount of ZnO particles is concentrated in the textured surface.

In a preferred embodiment, the surface-rich composite of the invention with antibacterial properties comprises a textured surface with a high density nanopillars or cone-shape protrusions. Said topography enhances the bactericidal properties. In a more preferred embodiment, the composite of the invention presents pillared or conical protrusions with height between 100 and 200 nm, width between 100 nm and 400 nm, and pitch between 100 and 400 nm.

### Composites with an anti-reflective surface

Light reflection at an optical interface is an undesirable phenomenon as it produces glare in optical or display devices or reduces the light trapping efficiency of the photovoltaic devices, such as solar cell or lighting devices such as LEDs or OLEDs.

The textured surface of the composite of the invention presents anti-reflective properties. In a particular embodiment, the textured surface of the composite of the invention with anti-reflective properties presents conical protrusions having a mean width lower than the visible wavelength (400 nm). In another particular embodiment, the textured surface of the composite of the invention with anti-reflective properties presents a high density of nanopillars or cone-shape shape features with a width between 100 nm and 300 nm, height between 100 and 400 nm, and pitch between 100 and 300 nm, preferably around 250 nm width, 350 nm height and pitch around 250 nm.

The antireflective textured surface of the composite of the invention preferably comprises metal oxide particles, metal sulphide particles or nitride particles and mixtures thereof, or a mixture of metal and/or metal oxide particles, metal sulphide or nitride particles with carbon based particles. Thus, in a particular embodiment the invention relates to the use as anti-reflective material of the composite of the invention comprising metal oxide particles (such as TiO₂, or ZnO) and/or mixtures with metal and carbon based particles. Advantageously, in addition to antireflective property, these particles add mechanical strength to the textured surface of the composite of the invention, as well as photo-catalytic and self-cleaning properties to the textured surface of the composite of the invention.

In another particular embodiment, the invention relates to the use of the composite of the invention wherein the particles are metal oxide particles selected from silica, alumina, titanium oxide, zinc oxide, nickel oxide, silver oxide, copper oxide and mixtures thereof; metal sulphide particles selected from molybdenum disulphide, tungsten disulfide and mixtures thereof; and/or boron nitride particles as antireflective coating. Preferably, the particles of the composite of the invention with antireflective properties are selected from TiO₂, ZnO with size ranges between 10- 50 nm, pured or dopped with metal or carbon based particles with size ranges between 3 - 20 nm, such as carbon nanodot-TiO₂ and Au-TiO₂. These combinations can be also employed to broad the photo catalytic efficiency.

In a preferred embodiment, the particles are selected from metal and metal oxide particles doped with carbon dots. Preferably, the particles in the composite of the invention are titanium dioxide particles doped with carbon dots, even more preferably the particles of the composite are TiO₂ doped with carbon dots wherein the carbon dots have a mean size of between 2 and 5 nm.

Antireflective polymer surfaces have wide application in areas such as display, lighting or imaging systems, and particularly in photovoltaic devices such as solar cells. In these devices light reflection is critical to performance since7 it causes optical losses and hence conversion efficiency.

### EXAMPLES

### Example 1 - Preparation of composites of the invention containing carbon-based particles

### Example 1a) Preparation of a composite RGO/PS of the invention

Initially a stable dispersion of 5 mg/ml RGO is prepared by dispersing RGO flakes (1-5 µm in width) in ethanol, and applying several cycles of ultrasonication and dispersion using Ultraturrax dispersion tool (10000 rpm). Then, 100 µl of the dispersion of particles was applied per cm² of the polystyrene surface via spin coating at 1000 rpm. The excess of solvent was evaporated or eliminated via vacuum drying.

Subsequently, the coated polymer was imprinted with a mold with the negative superhydrophobic features patterned on it, by applying heat to a temperature of 160°C and 50 bars of pressure. Upon cooling, the composite having an imprinted textured surface was demolded. Figure 2b shows a SEM image of the prepared composite having a textured surface with 2 µm x 12 µm pillars.

### Example 1b) Preparation of SWCNT and MWCNT polymer composites of the invention

SWCNT or o-MWCNT dispersions (0.01-20 mg·ml⁻¹) were prepared in methanol, toluene or xylene. Tip ultrasonication and mechanical stirring cycles using an Ultraturrax dispersion tool (up to 10⁴ rpm) were carried out to enhance dispersion and to render stable dispersions of nanoparticles. Then, 100 µl of the dispersion of particles was applied per cm² of the polymer surface (polycarbonate, polypropylene or polyethylene) via spin coating at 1000 rpm. The excess of solvent was evaporated or eliminated via vacuum drying. Subsequently, nanoimprinting was carried out to generate a textured surface with superhydrophobic and self-cleaning properties

In a particular embodiment a MWCNT dispersion (10 mg·ml⁻¹) was prepared using methanol as a solvent. Tip ultrasonication and mechanical stirring cycles using an Ultraturrax dispersion tool (8·10³ rpm) were used to obtain a stable dispersion of nanoparticles. A volume of 200 µl was deposited over a polycarbonate film (2 cm²) by spin coating (1000 rpm, 1 minute). The film was heated to remove excess of solvent. Nanoimprinting was performed at 180°C and 7 bars for 20 minutes to prepare a superhydrophobic composites.

### Example 2: Characterization of the mechanical properties of the composite of example 1

The mechanical properties of the composite of example 1 were measured by means of a Tribo-Indenter. Measurements were carried out with a spherical diamond having a tip radius of 10 µm. Nanoindentation tests were carried out by applying load-unload cycles up to a maximum load of 200 µN. Nanoscratch tests were performed by moving the nanoindentation probe laterally while applying a variable load from 0 up to 300 µN. Further, the same nanoindentation and nanoscratch tests were performed on an imprinted PS polymeric matrix in order to compare the mechanical properties of the composite of example 1. The results can be summarized as follow:
- The nanoindentation tests showed a significant increment of the stiffness (up to 25%) and an increment of the reduced elastic modulus (up to 50%) in the surface-rich composite of the invention when compared with the imprinted polymeric matrix.
- The nanoscratch tests showed a significant increment of the normal force required to reach the critical point of delamination (pillar fracture) for the composite of the invention compared to the imprinted polymeric matrix.

The nanoscratch and nanoindentation tests above described were carried out on another composite of the invention having a textured surface and comprising a polystyrene matrix and carbon nanotubes particles concentrated in the textured surface. The nanoscratch tests showed an increment of more than ≥100% of the normal force required to reach the critical point of delamination (pillar fracture) for the imprinted composites compared to the imprinted polymeric matrix. Further, nanoindentation tests showed an increment of the stiffness up to 25%, as well as an increment of the reduced elastic modulus with respect to the imprinted polymeric matrix.

### Example 3: Characterization of wetting properties of composites belonging to the invention

Water wetting properties of different surface rich-composites of the invention having a textured surface consisting on pillars with 2 µm diameter and 12 µm height were measured using an optical tensiometer. The static and dynamic water contact angle (WCA) measurements were performed by using an optical tensiometer (Attension Theta, Biolin Scientific) and depositing droplets of 4 µL of deionized water onto the textured surface of composites of the invention. Advancing and receding WCA measurements were performed by using the tilt base method using a tilting speed of the sample stage of 90°/min. The resulting wetting measurements are summarized in the table of figure 3. The wetting measurements in table of figure 3 show that the rich surface composites belonging to the invention have a water contact angle (WCA) ≥150, and therefore, they are considered superhydrophobic in the context of the present invention. Moreover, PS-RGO (5 mg/ml), PC-MWCNT (10 mg/ml), PE-SWCNT (1 mg/ml) or PP-SWCNT (1 mg/ml) having a contact angle hysteresis below 10°, also present self-cleaning properties.

### Example 4: Preparation of TiO₂ /PMMA composite of the invention

In order to prepare a film of PMMA, a solution of PMMA (5 % wt.) in toluene was layered onto a PET substrate. Subsequently, a stable dispersion of titania particles (10-30 nm) in methanol (0.1-1 % wt.) was deposited on the PMMA thin film by spin-coating. The dispersion of titania particles had a Zeta potential of -40 mV in a pH range of 6 to 10. Afterwards, the substrate was imprinted by application of 170° C temperature and 45 bar pressure, with a moth-eye antireflective mold (Temicon, HT-AR-02). As result, an antireflective surface is created with nanoscopic features reinforced with TiO₂ nanoparticles. The SEM image of the textured surface of the resulting composite of the invention is shown in figure 2c.

### Example 5: Characterization of optical properties of the TiO₂ /PMMA composite of example 4

Total reflectance and total transmittance of PMMA flat polymer (PMMA flat), textured PMMA (PMMA AR), TiO₂/PMMA (PMMA + 0.1% wt.TiO₂ flat), and nanoimprinted TiO₂ rich PMMA (PMMA + 0.1% wt. TiO₂ AR) were determined by using a spectrophotometer equipped with an integrating sphere. Three measurements were taken for each sample in different points of the sample. Figure 4 shows the total reflectance (figure 4a) and total transmittance (figure 4b) in the visible spectrum range (400-700 nm) of the measured samples.

The total reflectance of the PMMA flat film was around 7% for all the studied range, while the corresponding to the 0.1% wt. TiO₂/PMMA flat composite was higher than 8% (figure 4a). Hence, the particles increased the reflectivity of the composite. On the other hand, the total reflectance of the PMMA imprinted films decreased up to 4 %, and were lower than 4% for the imprinted composite TiO₂/PMMA (PMMA + 0.1% wt.TiO₂ AR) belonging to the invention. The total transmittance measurements in figure 4b reveal the same behavior.

### Example 6: Characterization of photo-catalytical properties of the TiO₂ /PMMA composite of example 4

The photo-catalytical activity of the TiO₂/PMMA composite of example 4 was measured by following the degradation of Rhodamine-B (RhB) under UV light. For this, a water solution of RhB was prepared and its degradation with UV light (Honle UV 400 F/2 400 W; wavelength: 260-600 nm) was monitored after intervals of 10 min time following the intensity of the characteristic peak of RhB at 554 nm using an (Agilent Cary 5000 UV-Vis-NIR) spectrophotometer.

The photo catalytic degradation rate measurements of RhB for TiO₂/PMMA and imprinted AR surfaces is shown in figure 4c. The degradation efficiency is defined as C/C₀, where C₀ is the initial concentration of RhB after 30 min period in the dark for equilibrium adsorption and C is the RhB concentration upon irradiation. As the figure 4c shows, all composite surfaces showed a significant photodegradation efficiency improvement and the catalytic performance increased as the ratio of filler on the film increased. A photodegradation efficiency of approximately 60 % degradation in 50 min was obtained for the 1% wt. TiO₂/PMMA AR imprinted composite.

### Example 7: Characterization of the mechanical properties of the TiO₂ /PMMA composite of example 4

The mechanical characteristics of the TiO₂ /PMMA composite of example 4 was assessed by means of scratch tests as well as indentation measurements performed with a nanoindenter (HYSITRON TI-950-Tribolndenter) and compared with the corresponding to an imprinted PMMA polymer film. The analysis of the measurements gave the following results:
1. The mechanical properties of the surfaces were studied with the nanoindenter making incremental load and unload cycles until a final load of 500 µN was reached. Under these conditions, the maximum penetration of the tip was 140 nm for PMMA and 125 nm for the TiO₂/PMMA composite of example 4. The lower tip penetration on the textured surface of the composite of the invention indicates an increase in hardness. Further, the nanoindentation tests revealed an increase of the reduced elastic modulus (up to 31%) and an increment of up to 37% of the apparent stiffness of the textured surface of the TiO₂/PMMA composite of example 4.
2. The nanoscratch tests performed by applying a constant force of 500 µN allowed determining the friction coefficient of the surface for both surfaces. Nanoimprinted TiO₂/PMMA surface-rich nanocomposite showed a value for the friction coefficient higher (up to 40%) than the imprinted PMMA film.

### Example 8: Antimicrobial characterization of TiO₂/PMMA and ZnO/PMMA composites of the invention

### Fabrication of TiO₂- PMMA nanocomposite

A TiO₂ nanoparticle dispersion was initially prepared in methanol (1 % wt.) by ultrasonication. Subsequently, the dispersion was spin coated on the surface of a PMMA film. On this film, a nanocomposite nanocone structure was fabricated by nanoimprinting at 170°C and 45 bars for 5 minutes following the process of the invention.

### Fabrication of ZnO- PMMA nanocomposite

A ZnO nanoparticle dispersion was initially prepared in methanol (1 % wt.) by ultrasonication. Subsequently, the dispersion was spin coated on the surface of a PMMA film. On this film, a nanocomposite nanocone structure was fabricated by nanoimprinting at 170°C and 45 bars for 5 minutes following the process of the invention.

### Characterization of the antimicrobial properties:

### - Bacteria culture and viability testing

Staphylococcus Aureus (S. Aureus), a Gram-positive bacteria expressing Green Fluorescent Protein (GFP), was employed as model bacteria to evaluate the antibacterial properties of the imprinted PMMA composite surfaces. Three replicates of each comparing pristine PMMA, flat PMMA-TiO₂ composite, PMMA-TiO₂ surface-rich composite of the invention (NI PMMA-TiO₂), flat PMMA-ZnO composite and PMMA-ZnO surface-rich composite of the invention (NI PMMA-ZnO) were tested. S. Aureus was growth overnight on Luria Broth (LB) media supplemented with erythromycin at a concentration of 1 µg/ml overnight at 37°C shaking at 250 rpm. All PMMA substrates were placed into 12-well microplates. The S. aureus overnight culture was diluted 100 times. 2 ml of this bacterial suspension was incubated on each substrate. After 30 minutes LB was removed and replaced with fresh medium. S. Aureus was then allowed to grow on substrates for 6 hours.

After the incubation time, the medium was removed and the substrates were washed with PBS 1X twice. Then, the PMMA-TiO₂ composites were immersed on PBS and exposed to UV light for 1 minute. Afterwards, the substrates were washed twice using PBS and stained with Propidium Iodide at a concentration 0.13 µl/ml in Tris HCl buffer at pH 7.4 for 15 minutes. Finally, the composite substrates were washed twice with PBS buffer and mounted to be visualized on a fluorescence microscope.
The antibacterial properties of the PMMA imprinted composites were assessed by fluorescence microscopy. The total number of S. Aureus cells attached to the surfaces was determined by the green GFP fluorescence emission, while dead cells were stain red by Propidium Iodide. The number of live and dead cells was counted using the NIH image analysis software Image J and was plotted as percentages of live and dead cells.

### - Characterization of the antimicrobial properties upon UV irradiation

S. Aureus was cultured over the three different substrates for 6 hours on PMMA-TiO₂ and PMMA-ZnO substrates. Subsequently, the PMMA-TiO₂ composites exposed to UV light (Honle UV 400 F/2 400 W; wavelength: 260-600 nm) for 1 minute. Then, both substrates were stained with Propidium Iodide to quantify the viability of S. Aureus by fluorescence microscopy.

Figure 5 shows the summary of the viability tests for the assessment of the antibacterial properties of the sample. Figure 5 shows that only 5% of bacteria were dead on the flat PMMA polymeric film. The flat PMMA-TiO₂ composite increased the bactericidal percentage up to 20% whereas the flat PMMA-ZnO composite of the invention increased the bactericidal percentage up to 50%. However, the bactericidal effect was improved up to 90% by the PMMA/TiO₂ (NI PMMA-TiO₂) and PMMA/ZnO (NI PMMA-ZnO) composites of the invention.

### Example 9: Preparation of TiO₂-CD/PMMA composite of the invention

Carbon dots were prepared by mixing 3 gr of citric acid and 6 g of urea in 20 mL of deionized water. This mixture was heated in a domestic microwave (800 W) for 3 minutes. Then, the solid was diluted in deionized water and centrifuged (10.000 rpm, 10 min) to remove the agglomerates. After centrifugation, the supernatant contained a stable carbon dots solution (2-5 nm). TiO₂ doped with carbon dots (TiO₂-CD) were prepared by mixing 5 mg of TiO₂ with 5mL of carbon dots stable solution. After stirring 24 hours at room temperature, the mixture was centrifuged and the resultant precipitate contained the TiO₂-CD nanoparticles.

To prepare a film of PMMA, a solution of PMMA in toluene (7.5 % wt.) was layered onto a PET substrate. Subsequently, a stable dispersion of TiO₂-CD in methanol (0,1-1 % wt) was deposited on the PMMA thin film by spin-coating. Afterwards, the substrate was imprinted by pressing a moth-eye antireflective mold (Temicon, HT-AR-02) while applying heat until 170° C of temperature and 45 bars of pressure. As result, an antireflective surface is created with nanoscopic features reinforced with TiO₂-CD nanoparticles.

### Example 10: Characterization of visible photo-catalytic properties of the TiO₂ CD/PMMA composite of example 9

The photo-catalytic degradation rate of Rhodamine-B (RhB) for TiO₂/PMMA composite of example 9 under visible light was measured. For this, a water solution of RhB was prepared and its degradation with visible light (White LED; 20 Watt, wavelength: 400-700 nm) was monitored after intervals of 15 min time following the intensity of the characteristic peak of RhB at 554 nm using an (Agilent Cary 5000 UV-Vis-NIR) spectrophotometer.

Figure 6A shows the photo catalytic capacity of TiO₂-CD /PMMA composites having different amounts of TiO₂-CD assessed in terms of RhB degradation with time. An imprinted surface without TiO₂-CD was used as a control sample. The degradation efficiency is defined here as C/C₀, wherein C₀ is the initial concentration of RhB after 30 min in the dark for equilibrium adsorption with the surface and C is the RhB concentration at the 15 min irradiation intervals. As the figure shows, all composite surfaces showed an increase in photodegradation with exposure time. The catalytic performance increased as the ratio of filler on the film increased. The control (PMMA-AR control) showed a slight drop on the RhB fluorescence emission that is attributed to the direct photo bleaching effect of the intense light on the bye molecule. A photodegradation efficiency of approximately 50 % degradation in 250 min was obtained for the 1% TiO₂-CD/PMMA AR imprinted composite.

### Example 11: Antimicrobial characterization of TiO₂-CD/PMMA composites of the invention

### - Bacteria culture and viability testing

PMMA-TiO₂ surface-rich composite of the invention (NI PMMA-TiO₂), PMMA-TiO₂-CD surface-rich composite of the invention (NI PMMA-TiO₂-CD) were fabricated following the described procedure in example 9.
Staphylococcus Aureus (S. Aureus), a Gram-positive bacteria expressing Green Fluorescent Protein (GFP), and Escherichia Coli (E.coli), a Gram-negative bacteria were employed as model bacteria to evaluate the antibacterial properties of the imprinted PMMA composite surfaces. Three replicates of each comparing pristine PMMA, PMMA-TiO₂ surface-rich composite of the invention (NI PMMA-TiO₂), PMMA-TiO₂-CD surface-rich composite of the invention (NI PMMA-TiO₂-CD), were tested. S. Aureus was growth overnight on Luria Broth (LB) media supplemented with erythromycin at a concentration of 1 µg/ml overnight at 37°C shaking at 250 rpm. E.coli was growth overnight on Luria Broth (LB) media at 37°C shaking at 250 rpm. The antibacterial capability of the surfaces was evaluated according to the ISO standard no. 27447:2009, titled: Fine ceramics (advanced ceramics, advanced technical ceramics)Test method for antibacterial activity of semiconducting photocatalytic materials. For this a bacterial suspension of 2·10⁵ bacteria cell/ml is inoculated over the imprinted substrates and then exposed for 1 hour to visible light (White LED; 20 Watt, wavelength: 400-700 nm). After the exposure time, the substrates were washed three times with Soya Casein Digest Lecithin Polysorbate (SCDLP) broth medium. Then, 10-fold serial dilutions of the recovered volume were plated on an agar Petri dish and incubated during 24 hours. After incubation time the number of colonies were counted corresponding to the bacteria that survive.

Figure 6B and 6C show in absolute numbers the S.aureus and E.coli bacteria cells that survived after the illumination period for the different substrates. The results show that that the number of total bacteria recovered decreased on the NI PMMA-TiO₂-CD surface-rich composite of the invention compared to the NI PMMA-TiO₂ and PMMA-TiO₂ surface-rich composite of the invention and the pristine PMMA.

## Claims

1. A composite comprising a) a textured surface with a plurality of protrusions, and b) a bulk portion; wherein both the textured surface and the bulk portion comprise a polymeric matrix and particles having a mean size of between 1 nm and 100 µm, wherein the polymer in the polymeric matrix is a thermoplastic polymer; and wherein said composite is **characterized in that** the major amount of said particles is concentrated in the textured surface.

2. The composite according to claim 1, wherein the protrusions in the textured surface present a height between 5 nm and 1000 µm, a width between 5 nm and 1000 µm and an interval between the protrusions from 5 nm to 1000 µm.

3. The composite according to claim 1 or 2, wherein between 30 % and 99% wt. of the total amount of the particles in the composite is concentrated in the textured surface, preferably between 60 and 90% wt.

4. The composite according to anyone of claims 1 to 3, wherein the particles are selected from carbon based particles, metal particles, metal oxide particles, sulphide particles, carbide particles, nitride particles, and mixtures thereof.

5. The composite according to claim 4, wherein the carbon based particles are selected from carbon nanotubes, carbon nanowires, reduced graphene oxide flakes, carbon nanoribbons, carbon nanorods, carbon nanodots, fullerenes, graphene flakes, carbon black, graphite, carbon nanofibers and mixtures thereof.

6. The composite according to claim 4, wherein the metal oxide particles are selected from silica, alumina, titanium oxide, zinc oxide, nickel oxide, silver oxide, copper oxide and mixtures thereof; wherein the metal sulphide particles are selected from molybdenum disulphide, tungsten disulfide and mixtures thereof; wherein the nitride particles are boron nitride particles, and wherein the metal particles are selected from Ag, Al, Au, Bi, Co, Cr, Cu, Fe, Ge, In, Ir, Mo, Nd, Ni, Pd, Pt, Rh, Ru, Si, Sn, Ta, Ti, W, Zn and their alloys.

7. The composite according to claims 1 to 6, wherein the thermoplastic polymer is selected from poly(methyl methacrylate) (PMMA), polycarbonate (PC), polystyrene (PS), polypropylene (PP), polyethylene (PE), polyglycolide (PGA), poly(propylenefumarate) (PPF), polycyanoacrylate (PCA), polycaprolactone (PCL), poly(glycerol sebacate) (PGS), poly(glycerol sebacate acrylate) (PGSA), polyvinylidenefuoride (PVDF), polyvinylidene chloride (PVDC), polyethylene terephthalate (PET), polybutylene therephtalate (PBT), polyphenylene oxide (PPO), polyvinyl chloride (PVC), cellulose acetate (CA), cyclic olefin copolymer (COC), ethylene vinyl acetate (EVA), ethylene vinyl alcohol, (EVOH), polytetrafluoroethylene (PTFE), fluorinated ethylene propylene (FEP), perfluoroalkoxy (PEA), ethylene tetrafluoroethylene (ETFE), polyethersulfone (PES), chlorinated poly ethylene (CPE), polylactic acid (PLA), poly 3-hydroxybutyrate (P3HB), polybutylene adipate (PBA), polyethylene adipate (PEA), polybutylene succinate (PBS), polyphenylene sulfide (PPS), polysulfone (PSU), polytrimethylene terephthalate (PTT), polyurethane (PU), polyvinyl acetate (PVA), polyvinylidene chloride (PVDC), styrene acrylonitrile (SAN), polyetherketones (PEEK), polyvinylalcohol (PVA), polyhydroxyethylmethacrylate (PHEMA), poly(N-isopropylacrylamide) (PNIPAAm) and mixtures thereof.

8. A process for preparing the composite according to anyone of claims 1 to 7, comprising:
a) providing a thermoplastic polymer,
b) providing a stable dispersion of particles,
c) applying the dispersion of particles of step b) on the surface of the polymer of step a) to obtain a particle coating on the polymer,
d) imprinting the coated polymer obtained in step c) by heating until the polymer becomes fluid, and by pressing the coated polymer surface with a mold having micrometric and/or nanometric patterns with cavities, so that the polymer fills the mold cavities; and
e) cooling and demolding the composite from step d) to obtain a composite having a textured surface.

9. The process according to claim 8, wherein the dispersion in step b) contains between 0.001 and 50 %wt. of particles.

10. The process according to claims 8 or 9, wherein the particles are applied on the surface of the polymer by casting, spin coating, screen printing, jet printing, gas-assisted spraying, roll to roll printing or gravure roll coating.

11. A composite obtained by the process according to any one of claims 8 to 10.

12. Use of the composite according to anyone of claims 1 to 7 and 11 as structural coating.

13. Use of the composite according to anyone of claims 1 to 7 and 11 as super-hydrophobic coating for repelling liquids or anti-dust coating.

14. Use of the composite according to anyone of claims 1 to 7 and 11 as antireflective, antimicrobial or photo-catalytic coating.

15. A product having at least a surface coated with the composite according to anyone of claims 1 to 7 and 11.

## Patentansprüche

1. Verbundstoff, umfassend a) eine strukturierte Oberfläche mit einer Vielzahl von Vorsprüngen und b) einen Körperabschnitt; wobei sowohl die strukturierte Oberfläche als auch der Körperabschnitt eine Polymermatrix und Partikel mit einer mittleren Größe zwischen 1 nm und 100 µm aufweisen, wobei das Polymer in der Polymermatrix ein thermoplastisches Polymer ist; und wobei der Verbundstoff **dadurch gekennzeichnet ist, dass** der Großteil der Partikel in der strukturierten Oberfläche konzentriert ist.

2. Verbundstoff nach Anspruch 1, wobei die Vorsprünge in der strukturierten Oberfläche eine Höhe zwischen 5 nm und 1000 µm, eine Breite zwischen 5 nm und 1000 µm und einen Abstand von 5 nm bis 1000 µm zwischen den Vorsprüngen aufweisen.

3. Verbundstoff nach Anspruch 1 oder 2, wobei zwischen 30 Gew.-% und 99 Gew.-%, vorzugsweise zwischen 60 Gew.-% und 90 Gew.-% der Gesamtmenge der Partikel in dem Verbundstoff in der strukturierten Oberfläche konzentriert sind.

4. Verbundstoff nach einem der Ansprüche 1 bis 3, wobei die Partikel aus Partikeln auf Kohlenstoffbasis, Metallpartikeln, Metalloxidpartikeln, Sulfidpartikeln, Carbidpartikeln, Nitridpartikeln und Gemischen derselben ausgewählt sind.

5. Verbundstoff nach Anspruch 4, wobei die Partikel auf Kohlenstoffbasis aus Kohlenstoffnanoröhren, Kohlenstoffnanodrähten, Flocken aus reduziertem Graphenoxid, Kohlenstoffnanobändern, Kohlenstoffnanostäbchen, Kohlenstoffnanopunkten, Fullerenen, Graphenflocken, Ruß, Graphit, Kohlenstoffnanofasern und Gemischen derselben ausgewählt sind.

6. Verbundstoff nach Anspruch 4, wobei die Metalloxidpartikel aus Siliciumoxid, Aluminiumoxid, Titanoxid, Zinkoxid, Nickeloxid, Silberoxid, Kupferoxid und Gemischen derselben ausgewählt sind; wobei die Metallsulfidpartikel aus Molybdändisulfid, Wolframdisulfid und Gemischen derselben ausgewählt sind; wobei die Nitridpartikel Bornitridpartikel sind und wobei die Metallpartikel aus Ag, AI, Au, Bi, Co, Cr, Cu, Fe, Ge, In, Ir, Mo, Nd, Ni, Pd, Pt, Rh, Ru, Si, Sn, Ta, Ti, W, Zn und deren Legierungen ausgewählt sind.

7. Verbundstoff nach den Ansprüchen 1 bis 6, wobei das thermoplastische Polymer aus Polymethylmethacrylat (PMMA), Polycarbonat (PC), Polystyrol (PS), Polypropylen (PP), Polyethylen (PE), Polyglycolsäure (PGA), Polypropylenfumarat (PPF), Polycyanacrylat (PCA), Polycaprolacton (PCL), Polyglycerolsebacat (PGS), Polyglycerolsebacatacrylat (PGSA), Polyvinylidenfluorid (PVDF), Polyvinylidenchlorid (PVDC), Polyethylenterephthalat (PET), Polybutylenterephtalat (PBT), Polyphenylenoxid (PPO), Polyvinylchlorid (PVC), Celluloseacetat (CA), Cycloolefin-Copolymer (COC), Ethylen-Vinylacetat (EVA), EthylenVinylalkohol, (EVOH), Polytetrafluorethylen (PTFE), fluoriertem Ethylen-Propylen (FEP), Perfluoralkoxy (PEA), Ethylen-Tetrafluorethylen (ETFE), Polyethersulfon (PES), chloriertem Polyethylen (CPE), Polylactid (PLA), Poly-3-Hydroxybutyrat (P3HB), Polybutylenadipat (PBA), Polyethylenadipat (PEA), Polybutylensuccinat (PBS), Polyphenylensulfid (PPS), Polysulfon (PSU), Polytrimethylenterephthalat (PTT), Polyurethan (PU), Polyvinylacetat (PVA), Polyvinylidenchlorid (PVDC), Styrol-Acrylnitril (SAN), Polyetherketonen (PEEK), Polyvinylalkohol (PVA), Polyhydroxyethylmethacrylat (PHEMA), Poly(N-Isopropylacrylamid) (PNIPAAm) und Gemischen derselben ausgewählt ist.

8. Verfahren zur Herstellung des Verbundstoffs nach einem der Ansprüche 1 bis 7, umfassend:
a) Bereitstellen eines thermoplastischen Polymers,
b) Bereitstellen einer stabilen Partikeldispersion,
c) Aufbringen der Partikeldispersion aus Schritt b) auf die Oberfläche des Polymers aus Schritt a) zur Ausbildung einer Partikelbeschichtung auf dem Polymer,
d) Prägen des in Schritt c) ausgebildeten beschichteten Polymers durch Erhitzen, bis das Polymer flüssig wird, und durch Aufdrücken einer Form auf die beschichtete Polymeroberfläche, wobei die Form mikrometrische und/oder nanometrische Muster mit Aussparungen aufweist, so dass das Polymer die Formaussparungen füllt; und
e) Kühlen und Entformen des Verbundstoffs aus Schritt d) zur Ausbildung eines Verbundstoffs mit einer strukturierten Oberfläche.

9. Verfahren nach Anspruch 8, wobei die Dispersion in Schritt b) einen Partikelanteil zwischen 0,001 und 50 Gew.-% enthält.

10. Verfahren nach Anspruch 8 oder 9, wobei die Partikel durch Gießen, Rotationsbeschichten, Siebdruck, Strahldruck, gasgestütztes Sprühen, Rollezu-Rolle-Drucken oder Gravurwalzenbeschichtung auf die Oberfläche des Polymers aufgebracht werden.

11. Verbundstoff, hergestellt durch das Verfahren nach einem der Ansprüche 8 bis 10.

12. Verwendung des Verbundstoffs nach einem der Ansprüche 1 bis 7 und 11 als Strukturbeschichtung.

13. Verwendung des Verbundstoffs nach einem der Ansprüche 1 bis 7 und 11 als superhydrophobe Beschichtung zur Flüssigkeitsabweisung oder als Anti-Staub-Beschichtung.

14. Verwendung des Verbundstoffs nach einem der Ansprüche 1 bis 7 und 11 als Antireflexbeschichtung, antimikrobielle Beschichtung oder photokatalytische Beschichtung.

15. Produkt mit mindestens einer mit dem Verbundstoff nach einem der Ansprüche 1 bis 7 und 11 beschichteten Oberfläche.

## Revendications

1. Un composite comprenant a) une surface texturée avec une pluralité de saillies, et b) une partie brute ; la surface texturée et la partie brute, tant l'une que l'autre, comprennent une matrice polymère et des particules ayant une taille moyenne comprise entre 1 nm et 100 µm, le polymère dans la matrice polymère étant un polymère thermoplastique ; et ledit composite étant **caractérisé en ce que** la majeure partie desdites particules est concentrée dans la surface texturée.

2. Le composite selon la revendication 1, dans lequel les saillies dans la surface texturée présentent une hauteur comprise entre 5 nm et 1000 µm, une largeur comprise entre 5 nm et 1000 µm et un intervalle entre les saillies compris entre 5 nm et 1000 µm.

3. Le composite selon la revendication 1 ou la revendication 2, dans lequel entre 30 % et 99 % en poids de la quantité totale des particules dans le composite est concentré dans la surface texturée, de préférence entre 60 et 90 % en poids.

4. Le composite selon l'une quelconque des revendications 1 à 3, dans lequel les particules sont choisies parmi les particules à base de carbone, les particules métalliques, les particules d'oxyde métallique, les particules de sulfure, les particules de carbure, les particules de nitrure, et des mélanges de celles-ci.

5. Le composite selon la revendication 4, dans lequel les particules à base de carbone sont choisies parmi les nanotubes de carbone, les nanofils de carbone, les paillettes d'oxyde de graphène réduit, les nanorubans de carbone, les nanotiges de carbone, les nanoparticules de carbone, les fullerènes, les paillettes de graphène, le noir de carbone, le graphite, les nanofibres de carbone et des mélanges de ceux-ci.

6. Le composite selon la revendication 4, dans lequel les particules d'oxyde métallique sont choisies parmi la silice, l'alumine, l'oxyde de titane, l'oxyde de zinc, l'oxyde de nickel, l'oxyde d'argent, l'oxyde de cuivre et les mélanges de ceux-ci ; les particules de sulfure métallique sont choisies parmi le disulfure de molybdène, le disulfure de tungstène et les mélanges de ceux-ci ; les particules de nitrure sont des particules de nitrure de bore, et les particules métalliques sont choisies parmi Ag, Al, Au, Bi, Co, Cr, Cu, Fe, Ge, In, Ir, Mo, Nd, Ni, Pd, Pt, Rh, Ru, Si, Sn, Ta, Ti, W, Zn et les alliages de ceux-ci.

7. Le composite selon les revendications 1 à 6, dans lequel le polymère thermoplastique est choisi parmi le poly(méthacrylate de méthyle) (PMMA), le polycarbonate (PC), le polystyrène (PS), le polypropylène (PP), le polyéthylène (PE), le polyglycolide (PGA), le poly(propylènefumarate) (PPF), le polycyanoacrylate (PCA), la polycaprolactone (PCL), le poly(glycérol sébacate) (PGS), le poly(acrylate de sébacate de glycérol) (PGSA), le polyfluorure de vinylidène (PVDF), le chlorure de polyvinylidène (PVDC), le polyéthylène téréphtalate (PET), le polytéréphtalate de butylène (PBT), l'oxyde de polyphénylène (PPO), le chlorure de polyvinyle (PVC), l'acétate de cellulose (CA), le copolymère d'oléfines cycliques (COC), l'éthylène-acétate de vinyle (EVA), l'éthylène-alcool vinylique, (EVOH), le polytétrafluoroéthylène (PTFE), l'éthylène-propylène fluoré (FEP), le perfluoroalcoxy (PEA), l'éthylène-tétrafluoroéthylène (ETFE), le polyéthersulfone (PES), le polyéthylène chloré (CPE), l'acide polylactique (PLA), le poly 3-hydroxybutyrate (P3HB), l'adipate de polybutylène (PBA), l'adipate de polyéthylène (PEA), le succinate de polybutylène (PBS), le sulfure de polyphénylène (PPS), le polysulfone (PSU), le téréphtalate de polytriméthylène (PTT), le polyuréthane (PU), l'acétate de polyvinyle (PVA), le chlorure de polyvinylidène (PVDC), le styrène acrylonitrile (SAN), les polyéthercétones (PEEK), l'alcool polyvinylique (PVA), le méthacrylate de polyhydroxyéthyle (PHEMA), le poly(N-isopropylacrylamide) (PNIPAAm) et les mélanges de ceux-ci.

8. Un procédé pour la préparation du composite selon l'une quelconque des revendications 1 à 7, le comprenant :
a) le fait de fournir un polymère thermoplastique,
b) le fait de prévoir une dispersion stable de particules,
c) le fait d'appliquer la dispersion de particules de l'étape b) sur la surface du polymère de l'étape a) pour obtenir un revêtement de particules sur le polymère,
d) le fait d'imprimer le polymère revêtu obtenu dans l'étape c) en chauffant jusqu'à ce que le polymère devienne fluide, et en pressant la surface du polymère revêtu avec un moule ayant des motifs micrométriques et/ou nanométriques avec des cavités, de sorte que le polymère remplisse les cavités du moule ; et
e) le fait de refroidir et de démouler le composite de l'étape d) pour obtenir un composite ayant une surface texturée.

9. Le procédé selon la revendication 8, dans lequel la dispersion de l'étape b) contient entre 0,001 et 50 % en poids de particules.

10. Le procédé selon la revendication 8 ou la revendication 9, dans lequel les particules sont appliquées sur la surface du polymère par coulée, revêtement par centrifugation, sérigraphie, impression par jet, pulvérisation assistée par gaz, impression rouleau à rouleau ou revêtement par rouleau de gravure.

11. Un composite obtenu par le procédé selon l'une quelconque des revendications 8 à 10.

12. Utilisation du composite selon l'une quelconque des revendications 1 à 7 et 11 en tant que revêtement structurel.

13. Utilisation du composite selon l'une quelconque des revendications 1 à 7 et 11 en tant que revêtement super-hydrophobe pour repousser les liquides ou en tant que revêtement anti-poussière.

14. Utilisation du composite selon l'une quelconque des revendications 1 à 7 et 11 en tant que revêtement anti-réfléchissant, antimicrobien ou photo-catalytique.

15. Un produit ayant au moins une surface revêtue du composite selon l'une quelconque des revendications 1 à 7 et 11.
